(19) **Europäisches Patentamt**

**European Patent Office**

**Office européen des brevets**

(11) **EP 1 175 005 B1**

(12) **EUROPEAN PATENT SPECIFICATION**

(45) Date of publication and mention
of the grant of the patent:
**23.11.2005 Bulletin 2005/47**

(51) Int Cl.⁷: $H03G\ 3/30$

(21) Application number: **01116531.3**

(22) Date of filing: **09.07.2001**

(54) **Fast attack automatic gain control (AGC) loop for narrow band systems**

Automatische Verstärkungsregelschleife mit kurzer Ansprechzeit für schmalbandige Systeme

Boucle de commande automatique de gain à réponse rapide pour systèmes à bande étroite

(84) Designated Contracting States:
**AT BE CH CY DE DK ES FI FR GB GR IE IT LI LU MC NL PT SE TR**

(30) Priority: **12.07.2000 US 614668**

(43) Date of publication of application:
**23.01.2002 Bulletin 2002/04**

(73) Proprietor: **MOTOROLA, INC.**
**Schaumburg, IL 60196 (US)**

(72) Inventors:
 • **Graham, David James**
 **Davie, Florida (US)**

 • **Rozenthal, Mark**
 **Rehovot, Israel 76560 (IL)**
 • **Korol, Victor**
 **Rehovot (IL)**

(74) Representative: **McCormack, Derek James et al**
**Optimus,**
**Grove House,**
**Lutyens Close,**
**Chineham Court**
**Basingstoke, Hampshire RG24 8AG (GB)**

(56) References cited:
 **EP-A- 0 612 144        WO-A-95/30275**
 **US-A- 5 742 899        US-A- 5 901 347**

## Description

## FIELD OF THE INVENTION

The present invention relates to a fast attack automatic gain circuit and an RF receiver and a method using such a circuit.

## BACKGROUND OF THE INVENTION

A radio communication system includes, as a minimum, a transmitter and a receiver. The transmitter and the receiver (which are often each part of combined transceiver unit) are interconnected by a radio-frequency (RF) wireless channel, which provides transmission of a communication signal therebetween. A receiver generally includes an amplifier, which is coupled to the receiving element (an antenna). The amplifier is characterized by a gain, which can be adjusted in a predetermined range, using a control signal. Many receivers also include a device which automatically adjusts the gain of the amplifier according to the level of the received signal. The process of adjusting the gain, according to which a received signal should be amplified, is called Automatic Gain Control (AGC).

In Time Division Multiple Access (TDMA) communication systems, an RF channel is shared among users attempting to access the radio system in certain of the time-division-multiplexed time slots. This enables transmission of more than one signal at the same frequency, allowing the sequential time-sharing of each channel by several subscribers. The time slots are arranged in periodically repeating frames. Each of the frames includes a certain number of time slots and each of the slots provides a signal for a specified user. Nowadays, the signal is in a digital form.

TETRA (Trans-European Trunked Radio (also known as Terrestrial Trunked Radio)) is a system specified by the European Telecommunications Standards Institute (ETSI) in which a set of standards are laid down by which digital communications especially in a TDMA form are to take place in modern communications. In particular, TETRA Direct Mode Operation (European standard ETS 300-392-2), for example, for direct communication between users operates using 1:4 TDMA format. Each frame is divided into four time slots. Each receiver operating in this system receives a signal in only one of the four time slots per frame. Such systems require either receivers that have a dynamic range, large enough to account for all signal levels, or a receiver with a very fast AGC, which can adapt very rapidly to changing levels of received signals. The received signal has a preamble length of about 0.2 ms and the AGC response should be established during this period.

US Patent 5,742,899 to Blackburn et al., entitled "Fast Attack Automatic Gain Control (AGC) Loop for Narrow Band Receiver" is directed to a fast attack AGC loop having a first feedback loop with selectable response shapes and a second feedback loop with selectable response shapes. Response shape selection is based upon fast pull-down operation mode, overshoot recovery operation mode and steady state operation mode. The system described in the this reference is dedicated for operating in TDMA, and its response time is 1.5 ms for 25 kHz intermediate frequency baseband. The system has been optimized for the case when there is continuous transmission of RF power, thus allowing AGC settling to occur at the end of a time slot.

However, the prior art loop described in the said reference is not suitable for use in narrow band RF receivers or transceivers, e.g. for use in TDMA, in which the RF power is received in discontinuous bursts, such as in the TETRA Direct Mode Operation (DMO) because the response time of the loop is not sufficiently fast.

## SUMMARY OF THE PRESENT INVENTION

In accordance with the present invention in a first aspect, there is provided an AGC (automatic gain control) circuit comprising:

a forward transmission path having an input to receive, in use, an input RF signal and an output, to provide, in use, an output baseband signal;
a variable gain AGC amplifier in the forward transmission path which amplifier has a control input and is responsive to a control signal applied thereto to vary its gain;
a feedback loop, coupled from the output of said forward transmission path and to said control input of said amplifier;
an integrator coupled to said control input of said amplifier; and,
a voltage source coupled to said integrator and to said control input of said amplifier,

wherein said feedback loop includes a signal detector (218) which has a predetermined non-linear gain response in which the gain continuously increases for an increase in input signal level;
wherein the AGC circuit is operable to receive a RF signal provided in a plurality of signal time slots, each pair of signal slots being interleaved by at least one empty time slot, and the feedback loop is operable to be in a closed loop mode to apply a fast attack to change a gain of the variable gain amplifier when a RF signal in a signal time slot is first received.

In the AGC circuit according to the first aspect of the invention, the forward path may include a mixer to which an output signal from the variable gain AGC amplifier is applied. The mixer may comprise a down mixer providing as an output signal a detected signal at baseband frequency.

The forward transmission path may include a low pass filter, e.g. located in the path after a mixer, and at least two feedback loops connected between the forward transmission path and the control input of the amplifier, including a first feedback loop connected to the forward transmission path before the low pass filter, e. g. between a mixer and the filter, and a second feedback loop connected to the forward transmission path after the low pass filter, each of the feedback loops incorporating a signal detector having a non-linear response gain response.

In the AGC circuit according to the first aspect of the invention the output signal provided at the output of the forward transmission path may include as phase components an in-phase (I) component and a quadrature (Q) component. The or each said signal detector of the feedback loop(s) may comprise an AGC detector, which in use receives the output signal and provides an output signal to the control input of said amplifier, the output signal being related to a non-linear combination of the I and Q phase components of said output signal.

In operation of the AGC circuit according to the first aspect of the invention, dependence of the gain G of the or each said signal detector on the level S of the baseband signal presented thereto may be a relationship represented by:

$$G = G_0 + kS^{1+\Delta}, \qquad \text{(Equation 1)}$$

where G is the gain of AGC loop, S is the signal level and $G_0$, $k$ and $\Delta$ are predetermined parameters ($G_0$, k and $\Delta > 0$). It is noted, that $\Delta$ can be a function of $S$.

A response of the or each said signal detector, to changes in the level of the signal presented thereto, may be to provide a variable bandwidth, wherein the variable bandwidth is higher according to the strength of the input signal being higher. A dependence of the variable bandwidth BW on the level S of the input baseband signal may be represented by:

$$BW = A \cdot (1+\Delta) \cdot S^{\Delta} \qquad \text{(Equation 2)}$$

An AGC circuit according to the first aspect of the invention which includes a first feedback loop and a second feedback loop as described earlier may be such that the signal detector of the first feedback loop has a signal strength detection threshold which is greater than the signal detector of the second feedback loop.

In the AGC circuit according to the first aspect of the invention the integrator may comprise an integrating capacitor and a resistor, the integrating capacitor having an output through the resistor coupled to the control input of the AGC amplifier. The voltage source may provide to the integrator, thereby determining a level of control signal at the control input, a predetermined voltage for a predetermined preset time period beginning at a predetermined time.

The control input to the AGC amplifier may include a driver providing a substantially linear change in amplifier gain or attenuation in response to the voltage applied thereto.

The AGC circuit according to the first aspect of the invention may include switching means allowing the AGC circuit to be switched between a first mode of operation in which the or each feedback loop is in an open loop state and a second mode of operation in which the or each feedback loop is in a closed loop state, such modes being obtained at predetermined times for predetermined time periods. The switching means may include an electrically operated switch for connecting an output terminal of the or each signal detector to the integrator, electrically controlled switches for connecting the voltage source to the integrator and the integrator to the control input of the variable gain amplifier and a controller for providing signals to operate the switches to provide switching between the first and second modes.

According to the present invention in a second aspect there is provided an RF receiver including an AGC circuit according to the first aspect. The RF receiver may be operable to receive RF signals provided in a plurality of signal time slots, each pair of adjacent signal time slots being interleaved by at least one empty time slot. The received signal may occupy one time slot of each four-slot frame of a TDMA communications operations mode, the other three slots received being empty.

In such operations, the AGC circuit may have a first operational mode in which the or each feedback loop is in an open state and a second operational mode in which the or each feedback loop is in a closed state, such modes being obtained at predetermined times for predetermined time intervals corresponding to a pattern of the signal time slots and empty time slots of the signal to be received. The first mode of operation is desirably initiated after the end of each signal time slot. The second mode of operation is desirably initiated before the start of each signal time slot.

The RF receiver according to the second aspect of the invention may be operable such that the signal to be detected is a signal received in discontinuous RF bursts, e.g. as in a direct mode operation (DMO) communications signal, usually from a transmitter operating in the same mode. The receiver and the transmitter may both be transceivers for operating according to a TDMA communication procedure. The receiver and the corresponding transmitter may communicate in accordance with TETRA standard direct mode operation (DMO) procedures.

According to the present invention in a third aspect there is provided a method of detecting an RF signal provided in a plurality of signal time slots, each pair of adjacent signal time slots being interleaved by at least one empty time slot, the method including use of a RF receiver according to the second aspect of the invention.

The present invention beneficially overcomes the response time limitations of the prior art by providing a novel AGC circuit, receiver incorporating the same and a method of operating the receiver to provide a fast attack automatic gain for narrow band systems with a response time of 0.5ms or less, in many cases 0.2 ms or less, making the circuit, receiver and method suitable for use in detecting RF signals provided in discontinuous bursts in a TDMA system.

Embodiments of the present invention will now be described by way of example with reference to the accompanying drawings, in which:

## BRIEF DESCRIPTION OF THE ACCOMPANYING DRAWINGS

Figure 1 is a schematic circuit diagram illustrating a fast attack automatic gain control (AGC) circuit, constructed and operational in accordance with an embodiment of the present invention;

Figure 2 is a graphical illustration of relationship between signal level and AGC detector gain in the AGC circuit of Figure 1, constructed and operational in accordance with an embodiment of the present invention;

Figure 3 is a schematic illustration of a method for operating the AGC circuit of Figure 1, operable in accordance with an embodiment of the present invention;

Figure 4 is a graphical illustration of modes of operation of the cicuit of Figure 1; and,

Figure 5 is a schematic circuit diagram illustrating a fast attack AGC circuit, constructed and operable in accordance with a further embodiment of the present invention.

## DETAILED DESCRIPTION OF EMBODIMENTS OF THE INVENTION

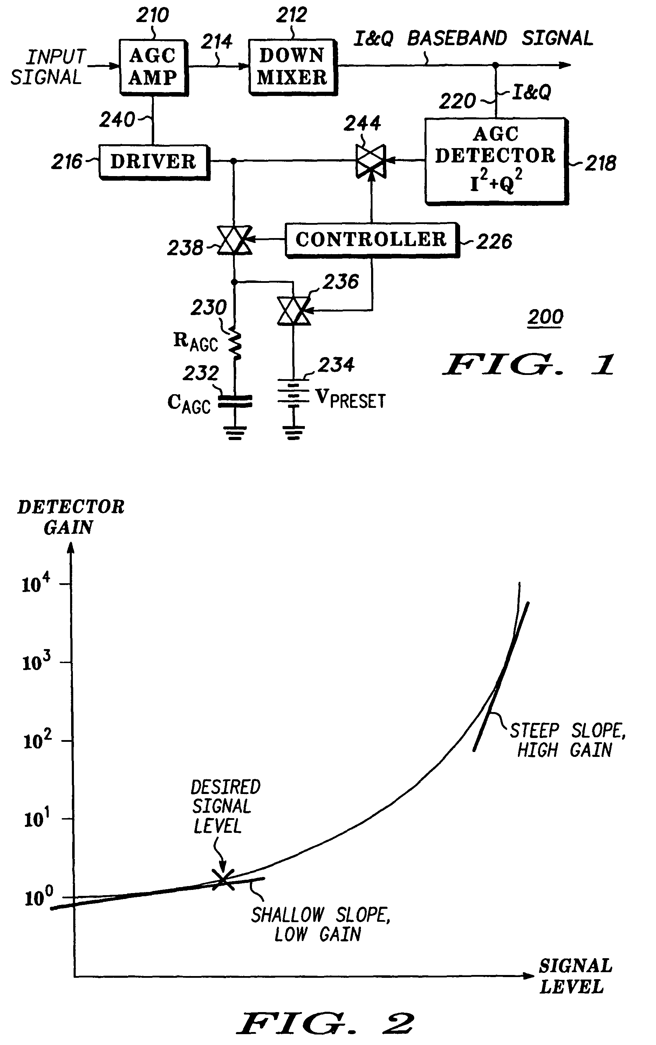

Reference is now made to Figure 1, which is a schematic illustration of a fast attack AGC loop, generally referenced 200, constructed and operable in accordance with an embodiment of the present invention.

AGC loop 200 includes an AGC amplifier 210 in a forward transmission path 214, a down mixer 212, a driver 216, an AGC detector 218, a controller 226, a damping resistor $R_{AGC}$ 230, an integrating capacitor $C_{AGC}$ 232, a voltage source $V_{PRESET}$ 234 and three switches 236, 238 and 244. AGC amplifier 210 is coupled to down mixer 212 and to driver 216. AGC detector 218 is coupled via a connection 220 to down mixer 212 and to switch 244. Controller 226 is coupled to switches 236, 238 and 244. Driver 216 is coupled to switches 238 and 244. Voltage source $V_{PRESET}$ 234 is coupled to switch 236. Damping resistor $R_{AGC}$ 230 is coupled to integrating capacitor $C_{AGC}$ 232 and to switch 238.

The input to AGC loop 200 is an RF signal. AGC amplifier 210 receives the input signal, amplifies it and provides it to down mixer 212. The output of down mixer 212 is typically a complex baseband signal, having phase components, i.e. an in-phase (I) component and a quadrature (Q) component. A sample of the baseband signal is delivered via connection 220 to AGC detector 218. An output signal produced by AGC detector 218 is fed to integrating capacitor 232 which produces a gain control signal 240 applied to the AGC amplifier 210 via a driver 216 in order to control the gain of the AGC amplifier 210. Driver 216 produces a linear slope response in the AGC amplifier 210, where the slope is defined as decibels (dB) of attenuation per volt change in amplifier gain control signal 240. The response could however be a non-liner one. The value of control signal 240 depends on the operation mode of AGC loop 200. Detailed description of each of the operation modes is presented below.

A first operation mode is begun at a known point in time in the timing sequence of a received TDMA signal in an empty time slot following a signal slot and preceding another signal slot in which the signal to be detected is to be provided. In the first mode, AGC loop 200 is opened, hence the feedback loop is not operational. At this stage, switch 244 is open and switches 236 and 238 are closed. Voltage source $V_{PRESET}$ 234 charges integrating capacitor $C_{AGC}$ 232. The voltage value is determined so that the attenuation of AGC amplifier 210 will be minimal. Typically, the attenuation value is substantially zero. The time required for charging integrating capacitor $C_{AGC}$ 232 is determined by a time constant related to the product of the resistance value of damping resistor $R_{AGC}$ 230 value and the capacitance value of integrating capacitor $C_{AGC}$ 232. The first operation mode is terminated when the charging of integrating capacitor $C_{AGC}$ 232 is completed.

At the beginning of the second operation mode, controller 226 opens switch 236, thereby disconnecting voltage source $V_{PRESET}$ 234 from integrating capacitor $C_{AGC}$ 232. The remainder of the charge at integrating capacitor $C_{AGC}$ 232 defines the value of control signal 240 and hence, the gain (or attenuation) of AGC amplifier 210. Controller 226 further closes switch 244, thereby closing AGC feedback loop 200. AGC detector 218 determines the input signal level applied thereto, based on determining the vector sum of the I and Q components (obtained from the sum of squares of the I and Q components), and provides the output signal to integrating capacitor $C_{AGC}$ 232. The voltage at integrating capacitor $C_{AGC}$ 232 determines the gain of AGC amplifier 210. The beginning of the second operation mode falls in an empty time slot before the next signal slot, AGC detector 218 will therefore first detect ambient noise of the system. Upon detection of this noise, AGC detector 218 provides an output signal which is applied to adjust the gain of AGC amplifier 210, thereby increasing the attenuation of the noise as described above.

The shape of the gain response of AGC detector 218 and hence, the gain of AGC loop 200 depends in a non-linear manner on the input signal level at the AGC detector 218. This gain is higher for signals that are greater than a desired signal value (AGC threshold) and low for signals that are below the threshold. An exemplary relationship for the gain variation can have the following form:

$$G = G_0 + kS^{1+\Delta}, \qquad \text{(Equation 1)}$$

where $G$ is the gain of AGC loop 200, $S$ is the signal level and $G_0$, $k$ and $\Delta$ are predetermined parameters ($G_0$, $k$, $\Delta > 0$). It is noted, that $\Delta$ can be a function of $S$.

The bandwidth of AGC loop 200 also depends on the signal level. Since in the type of signal to be detected, the slot, which precedes a signal slot, is generally empty, AGC loop 200 must be able to adapt itself to very fast changing signal levels. The signal rise time period can be less than 0.2 ms and the dynamic range of the signal can exceed 80 dB. This requires the loop bandwidth to be maximal for high level signals, so that the AGC attack (settling) time of the loop 200 is less than 0.2 ms. The attack time of AGC loop 200 is the time period, which is required for the AGC loop to reach steady state operation in response to an arbitrary input power level or to an arbitrary change in input power level. Typically, the dependence of the loop bandwidth on the signal level can be proportional to the derivative of the loop gain with respect to the signal level, and is of a form:

$$BW = A \cdot k \cdot (1+\Delta) \cdot S^{\Delta}, \qquad \text{(Equation 2)}$$

where $BW$ is a loop bandwidth, and $A$ is a predetermined parameter.

The settling time of AGC loop 200 depends on the value of integrating capacitor $C_{AGC}$ 232. To minimize the settling time, the value of integrating capacitor $C_{AGC}$ 232 must be as small, as possible, while still maintaining a stable loop. A practical limit for the value of integrating capacitor $C_{AGC}$ 232 is set by the loop dynamics. If the value of integrating capacitor $C_{AGC}$ 232 is too small, then there is a significant overshoot in the loop response, which leads to signal distortions at the beginning of the signal receive slot. This problem is solved by including the connection of damping resistor $R_{AGC}$ 230 in series with integrating capacitor $C_{AGC}$ 232. This connection enables the stability of the AGC loop to be improved and enables its response time to be reduced.

Reference is now made to Figure 2, which is a graphical illustration of the dependence of AGC loop 200 gain on the signal level, in accordance with the preferred embodiment of the present invention (Figure 1).

Typically, the dependence of AGC loop 200 gain on the signal level can be governed by Equation 1. For signal levels that are below a desired signal level (AGC threshold), the gain variations of AGC loop 200 are comparatively small. When the signal level exceeds the AGC threshold, the gain of AGC loop 200 begins to increase rapidly. The slope of the curve, which is proportional to the bandwidth of AGC loop 200, is steep for large signals above the threshold and not steep for small signals below the threshold. It means that AGC loop 200 has a fast response for the signals, which exceed the desired signal level and a slow response for low-level signals.

The second operation mode continues until the end of the signal slot.

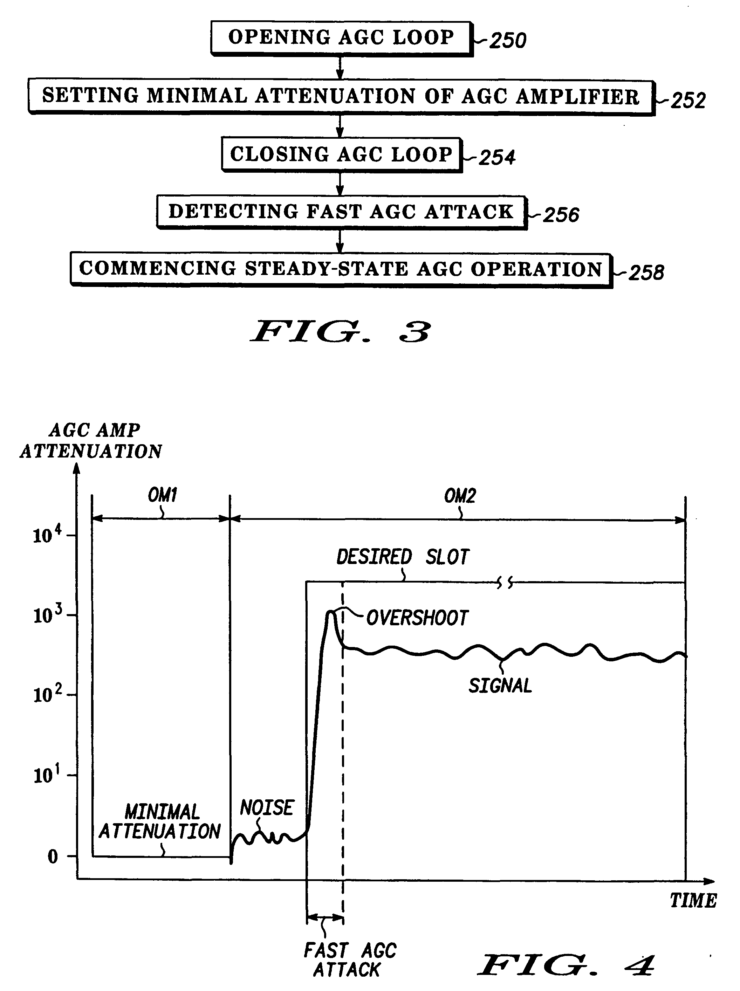

Reference is further made to Figure 3, which is a schematic illustration of a method for operating AGC loop 200 (Figure 1), operable in accordance with a further preferred embodiment of the present invention.

In step 250, AGC loop 200 is opened. With reference to Figure 1, controller 226 opens switch 244, thereby disconnecting AGC detector 218 from switch 238 and driver 216.

In step 252, a minimal attenuation of AGC amplifier 210 is set. With reference to Figure 1, controller 226 closes switches 236 and 238. Voltage source $V_{PRESET}$ 234 charges integrating capacitor $C_{AGC}$ 232. The time required for charging integrating capacitor $C_{AGC}$ 232 is determined by the product of the values of the resistance valu of damping resistor $R_{AGC}$ and the capacitance value of integrating capacitor $C_{AGC}$ 232. Controller 226 opens switch 236 when the charging of integrating capacitor $C_{AGC}$ 232 is completed. The voltage from charged integrating capacitor $C_{AGC}$ 232 is provided to AGC amplifier 210 via damping resistor $R_{AGC}$ 230, switch 238 and driver 216. The voltage value is determined so that the attenuation of AGC amplifier 210 will be minimal.

In step 254, AGC feedback loop is closed. With reference to Figure 1, controller 226 closes switch 244, thereby closing the AGC feedback loop. AGC detector 218 receives a baseband signal, produces an output signal and provides it to integrating capacitor $C_{AGC}$ 232 via switches 244 and 238. Since this operation is performed at times preceding the signal slots, AGC detector 218 will typically detect ambient noise of the system.

In step 256, a fast AGC attack is detected. With reference to Figure 1, the circuit works with the feedback loop of AGC loop 200 closed. AGC detector 218 determines a level of the sum of squares of the I and Q components of the input signal, and provides its output signal to integrating capacitor $C_{AGC}$ 232, via switches 244, 238 and damping resistor $R_{AGC}$ 230. The voltage at integrating capacitor $C_{AGC}$ 232 determines the gain of AGC amplifier 210. At the beginning of the signal slot, AGC detector 218 will detect a fast increase of a signal level (fast AGC attack). With reference to Figure 2, both the gain and the bandwidth of AGC detector 218 are maximal for large, rapidly varying signals. Consequently, the response time of the AGC feedback loop is minimal. As the signal approaches the desired threshold, the gain of AGC detector 218 decreases. This enables the system to proceed to the steady state operation mode with a minimal overshooting.

In step 258, the system proceeds to the steady state operation mode. With reference to Figure 1, after detecting the fast AGC attack, AGC detector 218 rapidly reduces the gain of AGC loop 200. As a result, the output baseband signal level approaches the desired value. AGC detector 218 continues to monitor and adjust the signal level within a comparatively narrow value range, close to the AGC threshold. This steady state operation mode continues until the end of the signal slot.

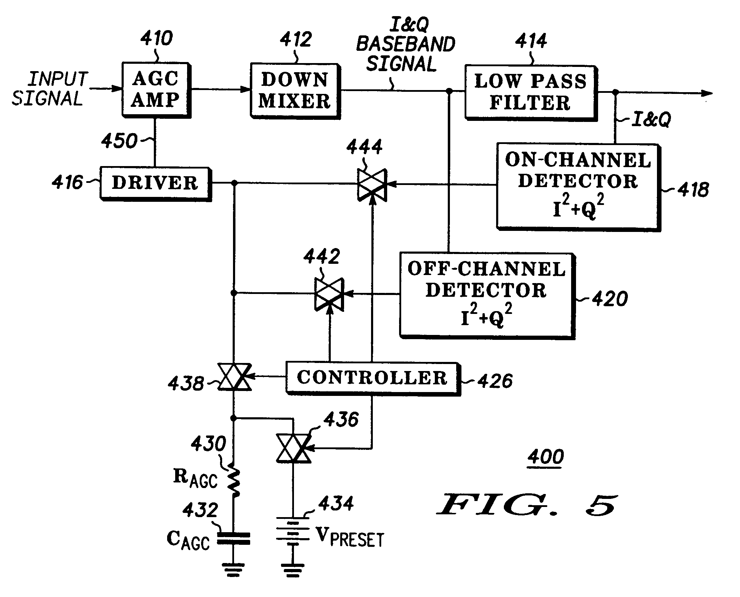

Reference is further made to Figure 4, which is a schematic illustration of different operation modes of AGC loop 200 in accordance with a further preferred embodiment of the present invention (Figure 1). The first operation mode (OM1) corresponds to steps 250 and 252 of Figure 3. At these steps, the AGC feedback loop is closed and the attenuation of AGC amplifier 210 is set to a minimal level. The second operation mode (OM2) corresponds to steps 254, 256 and 258 of Figure 3. In this mode, AGC detector 218 of Figure 1 monitors the signal level and controls the loop gain accordingly. At the beginning of the signal slot there is a short period of the fast AGC attack, accompanied by an overshoot. The duration of the fast AGC attack is typically less than 0.2 ms. The system rapidly recovers from the overshoot and continues to operate in the steady state mode until the end of the signal slot.

Reference is now made to Figure 5, which is a schematic illustration of a fast attack AGC loop, generally referenced 400, constructed and operable in accordance with a further embodiment of the present invention.

An AGC loop 400 includes an AGC amplifier 410, a down mixer 412, a driver 416, a low-pass filter 414, an on-channel detector 418, an off-channel detector 420, a controller 426, a damping resistor $R_{AGC}$ 430, an integrating capacitor $C_{AGC}$ 432, a voltage source $V_{PRESET}$ 434 and four switches 436, 438, 442 and 444. AGC amplifier 410 is coupled to down mixer 412 and to driver 416. Low-pass filter 414 is coupled to down mixer 412 and to on-channel detector 418. On-channel detector 418 is coupled to switch 444. Off-channel detector 420 is coupled to down mixer 412 and to switch 442. Controller 426 is coupled to switches 436, 438, 442 and 444. Driver 416 is coupled to switches 438, 442 and 444. Voltage source $V_{PRESET}$ 434 is coupled to switch 436. Damping resistor $R_{AGC}$ 430 is coupled to integrating capacitor $C_{AGC}$ 432 and to switch 438.

AGC loop 400 includes a forward transmission path and two feedback loops, coupled across the forward path. The forward transmission path includes AGC amplifier 410, down mixer 412 and low-pass filter 414. The input for AGC loop 400 is an RF signal, and the output is a baseband signal having I and Q components. The first feedback loop includes off-channel detector 420, which is coupled between the down mixer 412 output and low-pass filter 414 input. Off-channel detector 420 detects signals which are filtered out by the low pass filter 414 as well as those which are passed by the filter 414. Off-channel detector 420 controls the amplitude of adjacent channel (undesired) signals in the forward path. The second feedback loop includes on-channel detector 418, which is coupled to the output of low-pass filter 414. On-channel detector 418 controls the amplitude of on-channel (desired) signals in the forward path. Off-channel detector 420 and on-channel detector 418 provide their respective output signals to integrating capacitor $C_{AGC}$ 432. Driver 416 controls the gain of AGC amplifier 410 by providing a control signal 450. An exemplary dependence of the attenuation of AGC amplifier 410 on the voltage on integrating capacitor $C_{AGC}$ 432, can be a linear dependence of the decibels of attenuation on voltage. It is noted that there can be other types of dependencies of the attenuation of AGC amplifier 410 on the voltage on integrating capacitor $C_{AGC}$ 432. The value of control signal 450 depends on the operation mode of AGC loop 400. Detailed description of each of the operation modes is presented below.

At the beginning of the first operation mode, which corresponds to time instances preceding the signal slot, AGC loop 400 is open. Consequently, the feedback loops are not operating. Controller 426 opens switches 442 and 444 and closes switches 436 and 438. Voltage source $V_{PRESET}$ 434 charges integrating capacitor $C_{AGC}$ 432. The voltage value is determined so that the attenuation of AGC amplifier 410 will be minimal. The time period which is required for charging integrating capacitor $C_{AGC}$ 432 is specified by a product of the resistance value of damping resistor $R_{AGC}$ 430 and the capacitance value of integrating capacitor $C_{AGC}$ 432. The first operation mode is terminated when the charging of integrating capacitor $C_{AGC}$ 432 is completed.

At the beginning of the second operation mode, controller 426 opens switch 436, thereby disconnecting voltage source $V_{PRESET}$ 434 from integrating capacitor $C_{AGC}$ 432. The remainder of the charge at integrating capacitor $C_{AGC}$ 432 defines the value of control signal 450 and, hence, the gain (or attenuation) of AGC amplifier 410. Controller 426 further closes switches 444 and 442, thereby closing the AGC feedback loops. On-channel detector 418 monitors the desired baseband signal, and provides its output signal to the integrating capacitor $C_{AGC}$ 432. Off-channel detector 420 monitors undesired signal on adjacent channels. The gain of this detector is determined so that it reacts only to strong signals, which are mainly off-channel signals which are outside of the pass band of low-pass filter 414. This is because on-channel signals will already have been detected as signals above a lower threshold at the on-channel detector 418. Off-channel detector 420 provides an output signal which is combined with that of the on-channel detector 418 and fed to integrating capacitor $C_{AGC}$ 432, via switches 442 and 438 and damping resistor $R_{AGC}$ 430.

Both detectors 418 and 420 determine a level of signal overshoot SOS of the input signals applied to those detectors. The response shape of detectors 418 and 420 depends in a non-linear manner on the signal level and can be described by Equation 1. The graphical illustration of this dependence is presented in Figure 2. The bandwidth of AGC loop 400 also depends on the signal level. Since in the type of signal to be detected the slot, which precedes a signal slot, is generally empty, AGC loop 400 must be able to adapt itself rapidly to very fast changing signal levels at the beginning of the signal slot. The signal rise time period can be less than 0.2 ms and the dynamic range of the signal can exceed 80 dB. This requires the loop bandwidth to be maximal for high level signals, so that the AGC attack (settling) time is less than 0.2 ms. Typically, the dependence of the loop bandwidth on the signal level can be proportional to the derivative of the loop gain with respect to the signal level, and is described by Equation 2. Since the beginning of the second operation mode falls in an empty time slot which precedes the signal slot, off-channel detector 420 and on-channel detector 418 will first detect an ambient noise of the system. Upon detection of this noise, both detectors provide a respective output signal to AGC amplifier 410, thereby increasing the attenuation of the signal. In the second operation mode, both detectors detect the beginning of the signal slot, which is accompanied by a sharp increase in the signal level. According to Equations 1 and 2 and Figure 2, both the gain and the bandwidth of on-channel detector 418 and off-channel detector 420 are maximal for large, rapidly varying signals. Consequently, the response time of the AGC feedback loops is minimal. As the signal approaches the desired threshold, the gain of on-channel detector 418 decreases. This enables the system to proceed to the steady state operation with a minimal overshooting. The second operation mode is completed at the end of the signal slot. It is noted that the method illustrated in Figure 3 can be used for operating AGC loop 400.

**Claims**

1.  An AGC (automatic gain control) circuit comprising:

    a forward transmission path having an input (to 210) to receive, in use, an input RF signal and an output (of 212), to provide, in use, an output baseband signal;
    a variable gain AGC amplifier (210) in the forward transmission path which amplifier has a control input and is responsive to a control signal (240) applied thereto to vary its gain;
    a feedback loop (200), coupled from the output of said forward transmission path and to said control input of said amplifier;
    an integrator (230, 232), coupled to said control input of said amplifier; and,
    a voltage source (234), coupled to said integrator and to said control input of said amplifier,

    wherein said feedback loop includes a signal detector (218) which has a predetermined non-linear gain response in which the gain continuously increases for an increase in input signal level;
    wherein the AGC circuit is operable to receive a RF signal provided in a plurality of signal time slots, **characterised in that** each pair of signal slots is interleaved by at least one empty time slot, and the feedback loop is operable to be in a closed loop mode to apply a fast attack to change a gain of the variable gain amplifier when a RF signal in a signal time slot is first received.

2.  An AGC circuit according to claim 1 and wherein the forward path includes a low pass filter (414) and at least two feedback loops are connected between the forward transmission path and the control input of the amplifier, including a first feedback loop connected to the forward transmission path before the low pass filter and a second feedback loop connected to the forward transmission path after the low pass filter, each of the feedback loops incorporating a baseband signal detector (418, 420) having a non-linear gain response.

3.  An AGC circuit according to claim 1 or claim 2 wherein the or each detector is operable to have a gain which increases during a fast attack with the feedback loop in the closed loop mode.

4.  An AGC circuit according to any one preceding claim
    wherein the or each detector is operable to have a bandwidth which increases during the fast attack with the feedback loop in closed loop mode.

5.  An AGC circuit according to any one of the preceding claims and which includes switching means (244) operable to switch the or each feedback loop between a first mode of operation in which the or each feedback loop is open and a second mode of operation in which the or each feedback loop is closed, such modes being obtained at predetermined times for predetermined time periods.

6.  An AGC circuit according to claim 5 wherein the first mode of operation is applied during empty time slots and the second mode of operation is applied during signal time slots.

7.  An AGC circuit according to claim 6 wherein the second mode of operation is begun during an empty time slot prior to the start of a signal time slot.

8.  An AGC circuit according to any one of claims 5 to 7 wherein the variable gain amplifier (210) is operable to have a minimal attenuation when the feedback loop is switched from the first mode of operation to the second mode of operation.

9. An AGC circuit according to any one preceding claim and which includes a mixer (212) connected to an output of the variable gain amplifier.

10. An AGC circuit according to claim 9 and wherein the mixer is a down mixer providing in operation a detected baseband frequency signal.

11. An AGC circuit according to any one preceding claim and wherein the output baseband frequency signal of the forward transmission path includes as phase components an in-phase (I) component and a quadrature (Q) component.

12. An AGC circuit according to claim 11, wherein the or each said signal detector comprises an AGC detector, which in use receives said baseband signal and provides an output signal to the control input of said amplifier, the output signal being related to a combination of said I and Q phase components of said baseband signal.

13. An AGC circuit according to any one of the preceding claims and wherein dependence of the gain G of the or each said signal detector on the level S of said baseband signal presented thereto is represented by:

$$G = G_0 + kS^{1+\Delta},$$

where $G_0$, $k$ and $\Delta$ are predetermined parameters

$$(G_0, k, \Delta > 0).$$

14. An AGC circuit according to any one of the preceding claims, wherein the or each detector provides a dependence of variable bandwidth BW on the level S of the input baseband signal which is represented by:

$$BW = A \cdot (1+\Delta) \cdot S^{\Delta}$$

where $BW$ is loop bandwidth, S is signal strength and A and $\Delta$ are predetermined parameters.

15. An AGC circuit according to any one of the preceding claims and wherein said integrator comprises an integrating capacitor (232) and a resistor (230), the integrating capacitor having an output through the resistor coupled to said control input of said AGC amplifier.

16. An AGC circuit acccording to any one of the preceding claims and wherein the control input to the variable gain AGC amplifier includes a driver providing in operation a substantially linear change in gain or attenuation of the amplifier in response to a change in the voltage applied thereto.

17. An AGC circuit according to any one of the preceding claims and wherein said voltage source provides to said integrator, thereby determining a level of said control signal, a pre-determined voltage for a preset time period beginning at a predetermined time.

18. An AGC circuit according to claim 17 including a switch operable to connect the voltage source to the integrator, wherein the AGC circuit has a first mode of operation in which the or each feedback loop is open and a second mode of operation in which the or each feedback loop is closed and the switch is operable to connect the voltage source to the integator during the first mode of operation.

19. An AGC circuit according to claim 17 and wherein the switching means includes an electrically operated switch (244) for connecting an output terminal of the signal detector to the integrator, one or more electrically controlled switches (236,238) for connecting the voltage source to the integrator and the integrator to the control input of the variable gain amplifier and a controller (226) for providing signals to operate the switches to provide switching between the first and second modes.

20. An AGC circuit according to any one of the preceding claims wherein the or each feedback loop is operable to have a settling time in a fast attack of less than 0.2ms.

21. An AGC circuit according to any one of the preceding claims wherein the or each feedback loop is operable to detect a signal having a dynamic range of 80dB.

22. An R.F. receiver including an AGC circuit according to any one of the preceding claims.

23. An R.F. receiver according to claim 22 and which is operable to receive RF signals provided in a plurality of signal time slots, each pair of adjacent signal time slots being interleaved by at least one empty time slot.

24. An R.F. receiver according to claim 23 and wherein the AGC circuit has a first mode of operation in which the or each feedback loop is not operational and a second mode of operation in which the or each feedback loop is operational, such modes being obtained alternately at predetermined times for predetermined time intervals corresponding to a pattern of the signal time slots and empty time slots.

25. An RF receiver according to claim 24 and wherein the first mode of operation is initiated after the end of each signal time slot.

26. An RF receiver according to claim 24 or claim 25 and
wherein the second mode of operation is initiated before the start of each signal time slot.

27. An RF receiver according to any one of claims 22 to 26 and wherein the signal to be detected is a direct mode communications signal.

28. An RF receiver according to any one of claims 22 to 27 and wherein the signal to be detected is communicated in accordance with TETRA direct mode standards.

29. A method of detecting an RF signal provided in a plurality of signal time slots, **characterised in that** each pair of adjacent signal time slots is interleaved by at least one empty time slot, the method including use of a RF receiver according to any one of claims 22 to 28 to detect the signal.

30. A method according to claim 29 including applying at an input of the forward transmission path of the AGC circuit including the variable gain AGC amplifier an input RF signal and providing at the output of the forward transmission path and an input of an AGC detector of the AGC circuit a baseband signal; wherein the RF signal is received in a plurality of signal time slots, each pair of signal slots being interleaved by at least one empty time slot, and operating the or each feedback loop of the AGC circuit to be in a closed loop mode to apply a fast attack to change a gain of the variable gain AGC amplifier of the AGC circuit when a RF signal is first received in a signal time slot.

**Patentansprüche**

1. AGC-Schaltung (AGC = "automatic gain control"/ automatische Verstärkungssteuerung), umfassend:

   einen Vorwärtsübertragungspfad, der einen Eingang (zu 210) zum Empfangen, in Benutzung, eines Eingangs-HF-Signals und einen Ausgang (von 212) zum Bereitstellen, in Benutzung, eines Ausgangs-Basisbandsignals aufweist;
   einen AGC-Verstärker (210) mit variabler Verstärkung in dem Vorwärtsübertragungspfad, wobei der Verstärker einen Steuereingang aufweist und auf ein Steuersignal (240) anspricht, das an diesen angelegt wird, um dessen Verstärkung zu variieren;
eine Rückkopplungsschleife (200), die von dem Ausgang des Vorwärtsübertragungspfades und an den Steuereingang des Verstärkers gekoppelt ist;
einen Integrator (230, 232), der an den Steuereingang des Verstärkers gekoppelt ist; und
eine Spannungsquelle (234), die an den Integrator und an den Steuereingang des Verstärkers gekoppelt ist,

wobei die Rückkopplungsschleife einen Signaldetektor (218) umfasst, der einen vorbestimmten nicht-linearen Amplitudengang aufweist, bei der sich die Verstärkung kontinuierlich für eine Erhöhung des Eingangssignalpegels erhöht;
wobei die AGC-Schaltung betriebsfähig dazu ausgelegt ist, ein HF-Signal zu empfangen, das in einer Mehrzahl von Signalzeitschlitzen zur Verfügung gestellt ist, **dadurch gekennzeichnet, dass** jedes Paar von Signalschlitzen mit zumindest einem leeren Zeitschlitz verschachtelt ist und dass die Rückkopplungsschleife betriebsfähig dazu ausgelegt ist, sich in einem Modus mit geschlossener Schleife zu befinden, um einen schnellen Eingriff anzuwenden, um eine Verstärkung des Verstärkers mit variabler Verstärkung zu verändern, wenn ein HF-Signal in einem Signal-Zeitschlitz als erstes empfangen wird.

2. AGC-Schaltung nach Anspruch 1, wobei der Vorwärtspfad einen Tiefpassfilter (414) umfasst und zumindest zwei Rückkopplungsschleifen zwischen den Vorwärtsübertragungspfad und den Steuereingang des Verstärkers gekoppelt sind, einschließlich einer ersten Rückkopplungsschleife, die mit dem Vorwärtsübertragungspfad vor dem Tiefpassfilter verbunden ist und einer zweiten Rückkopplungsschleife, die mit dem Vorwärtsübertragungspfad nach dem Tiefpassfilter verbunden ist, wobei jede der Rückkopplungsschleifen einen Basisbandsignaldetektor (418, 420) aufweist, der einen nicht-linearen Amplitudengang aufweist.

3. AGC-Schaltung nach Anspruch 1 oder 2, wobei der oder jeder Detektor betriebsfähig dazu ausgelegt ist, eine Verstärkung aufzuweisen, der sich während eines schnellen Eingriffs erhöht, mit der Rückkopplungsschleife in dem Modus mit geschlossener Schleife.

4. AGC-Schaltung nach einem der vorhergehenden Ansprüche,
wobei der oder jeder Detektor betriebsfähig dazu ausgelegt ist, eine Bandbreite aufzuweisen, die sich während des schnellen Eingreifens erhöht, mit der Rückkopplungsschleife in dem Modus mit geschlossener Schleife.

5. AGC-Schaltung nach einem der vorhergehenden Ansprüche,
wobei die AGC-Schaltung Umschaltmittel (244) umfasst, die betriebsfähig dazu ausgelegt sind, die oder jede Rückkopplungsschleife zwischen einem ersten Betriebsmodus, in dem die oder jede Rückkopplungsschleife offen ist, und einem zweiten Betriebsmodus, in dem die oder jede Rückkopplungsschleife geschlossen ist, zu schalten, wobei derartige Modi zu vorbestimmten Zeiten für vorbestimmte Zeiträume erhalten werden.

6. AGC-Schaltung nach Anspruch 5, wobei der erste Betriebsmodus während leerer Zeitschlitze angewendet wird und der zweite Betriebsmodus während Signal-Zeitschlitzen angewendet wird.

7. AGC-Schaltung nach Anspruch 6, wobei der zweite Betriebsmodus während eines leeren Zeitschlitzes vor dem Start eines Signal-Zeitschlitzes begonnen wurde.

8. AGC-Schaltung nach einem der Ansprüche 5 bis 7, wobei der Verstärker (210) mit variabler Verstärkung betriebsfähig so ausgelegt ist, dass er eine minimale Dämpfung aufweist, wenn die Rückkopplungsschleife von dem ersten Betriebsmodus in den zweiten Betriebsmodus geschaltet wird.

9. AGC-Schaltung nach einem der vorhergehenden Ansprüche,
wobei die AGC-Schaltung einen Mischer (212) umfasst, der mit einem Ausgang des Verstärkers mit variabler Verstärkung verbunden ist.

10. AGC-Schaltung nach Anspruch 9, wobei der Mischer ein Abwärtsmischer ist, der im Betrieb ein detektiertes Basisbandfrequenzsignal zur Verfügung stellt.

11. AGC-Schaltung nach einem der vorhergehenden Ansprüche,
wobei das Ausgangsbasisband-Frequenzsignal des Vorwärtsübertragungspfades als Phasen-Komponenten eine In-Phase-Komponente (I-Komponente) und eine Quadratur-Komponente (Q-Komponente) umfasst.

12. AGC-Schaltung nach Anspruch 11, wobei der oder jeder Signaldetektor einen AGC-Detektor umfasst, der in Benutzung das Basisbandsignal empfängt und ein Ausgangssignal an dem Steuereingang des Verstärkers zur Verfügung stellt, wobei das Ausgangssignal von einer Kombination der I- und Q-Phasen-Komponenten des Basisbandsignals abhängt.

13. AGC-Schaltung nach einem der vorhergehenden Ansprüche,
wobei die Abhängigkeit der Verstärkung G des oder jedes Signaldetektors von dem Pegel S des Basisbandsignals, das ihm zugeführt wird, dargestellt wird durch:

$$G = G_0 + kS^{1+\Delta},$$

wobei $G_0$, k und $\Delta$ vorbestimmte Parameter mit ($G_0$, $k, \Delta > 0$) sind.

14. AGC-Schaltung nach einem der vorhergehenden Ansprüche,
wobei der oder jeder Detektor eine Abhängigkeit der variablen Bandbreite BW von dem Pegel S des Eingangsbasisbandsignals zur Verfügung stellt, was dargestellt wird durch:

$$BW = A \cdot (1 + \Delta) \cdot S^{\Delta},$$

wobei BW die Schleifenbandbreite, S die Signalstärke und A und $\Delta$ vorbestimmte Parameter sind.

15. AGC-Schaltung nach einem der vorhergehenden Ansprüche,
wobei der Integrator einen integrierenden Kondensator (232) und einen Widerstand (230) umfasst, wobei der integrierende Kondensator einen Ausgang hat, über den der Widerstand an den Steuereingang des AGC-Verstärkers gekoppelt ist.

16. AGC-Schaltung nach einem der vorhergehenden Ansprüche,
wobei der Steuereingang an den AGC-Verstärker mit variabler Verstärkung einen Treiber umfasst, der im Betrieb eine im Wesentlichen lineare Veränderung der Verstärkung oder der Dämpfung des Verstärkers als Antwort auf eine Veränderung in der Spannung, die daran angelegt wird, zur Verfügung stellt.

17. AGC-Schaltung nach einem der vorhergehenden Ansprüche,
wobei die Spannungsquelle dem Integrator, wodurch sie den Pegel des Steuersignals bestimmt, eine vorbestimmte Spannung für einen voreingestellten Zeitraum zur Verfügung stellt, der zu einer vorbestimmten Zeit beginnt.

18. AGC-Schaltung nach Anspruch 17, die einen Schalter umfasst, der betriebsfähig so ausgelegt ist, dass er die Spannungsquelle mit dem Integrator verbindet, wobei die AGC-Schaltung einen ersten Betriebsmodus, in dem die oder jede Rückkopplungsschleife offen ist und einen zweiten Betriebsmodus aufweist, in dem die oder jede Rückkoppelschleife geschlossen ist, und der Schalter betriebsfähig so ausgelegt ist, dass er die Spannungsquelle mit dem Integrator während des ersten Betriebsmodus verbindet.

19. AGC-Schaltung nach Anspruch 17, wobei die Umschaltmittel einen elektrisch betriebenen Schalter (244) zum Verbinden eines Ausgangsanschlusses des Signaldetektors mit dem Integrator, einen oder mehrere elektrisch gesteuerte Schalter (236, 238) zum Verbinden der Spannungsquelle mit dem Integrator und des Integrators mit dem Steuereingang des Verstärkers mit variabler Verstärkung und einen Controller (226) zum Bereitstellen von Signalen zum Betreiben der Schalter umfasst, um ein Schalten zwischen den ersten und den zweiten Modi zur Verfügung zu stellen.

20. AGC-Schaltung nach einem der vorhergehenden Ansprüche,
wobei die oder jede Rückkopplungsschleife betriebsfähig so ausgelegt ist, dass sie eine Einschwingzeit bei einem schnellen Eingriff von weniger als 0,2 ms hat.

21. AGC-Schaltung nach einem der vorhergehenden Ansprüche,
wobei die oder jede Rückkopplungsschleife betriebsfähig so ausgelegt ist, dass sie ein Signal mit einem dynamischen Bereich von 80 dB detektiert.

22. HF-Empfänger, der eine AGC-Schaltung gemäß einem der vorhergehenden Ansprüche umfasst.

23. HF-Empfänger nach Anspruch 22, der betriebsfähig so ausgelegt ist, dass er HF-Signale empfängt, die in einer Mehrzahl von Signal-Zeitschlitzen zur Verfügung gestellt werden, wobei jedes Paar von benachbarten Signal-Zeitschlitzen mit zumindest einem leeren Zeitschlitz verschachtelt ist.

24. HF-Empfänger nach Anspruch 23, wobei die AGC-Schaltung einen ersten Betriebsmodus, bei dem die oder jede Rückkopplungsschleife nicht betriebsbereit ist und einen zweiten Betriebsmodus aufweist, in dem die oder jede Rückkopplungsschleife betriebsbereit ist, wobei derartige Modi abwechselnd bei vorbestimmten Zeiten für vorbestimmte Zeitintervalle entsprechend einem Muster aus Signal-Zeitschlitzen und leeren Zeitschlitzen erhalten werden.

25. HF-Empfänger nach Anspruch 24, wobei der erste Betriebsmodus nach dem Ende jedes Signal-Zeitschlitzes initiiert wird.

26. HF-Empfänger nach Anspruch 24 oder 25, wobei der zweite Betriebsmodus vor dem Start jedes Signal-Zeitschlitzes initiiert wird.

27. HF-Empfänger nach einem der Ansprüche 22 bis 26, wobei das zu detektierende Signal ein Direktmodus-Kommunikationssignal ist.

28. HF-Empfänger nach einem der Ansprüche 22 bis 27, wobei das zu detektierende Signal gemäß TETRA-Direktmodus-Standards kommuniziert wird.

29. Verfahren zum Detektieren eines HF-Signals, das in einer Mehrzahl von Signal-Zeitschlitzen zur Verfügung gestellt wird, **dadurch gekennzeichnet, dass** jedes Paar von benachbarten Signal-Zeitschlitzen mit zumindest einem leeren Zeitschlitz verschachtelt wird, wobei das Verfahren die Verwendung eines HF-Empfängers gemäß einem der Ansprüche 22 bis 28 umfasst, um das Signal zu detektieren.

30. Verfahren nach Anspruch 29, dass das Anlegen eines Eingangs-HF-Signals an einen Eingang des Vorwärtsübertragungspfades der AGC-Schaltung einschließlich des AGC-Verstärkers mit variabler Verstärkung und das Bereitstellen eines Basisbandsignals an dem Ausgang des Vorwärtsübertragungspfades und an einem Eingang eines AGC-Detektors der AGC-Schaltung umfasst; wobei das HF-Signal in einer Mehrzahl von Signal-Zeitschlitzen empfangen wird,
wobei jedes Paar von Signalschlitzen mit zumindest einem leeren Zeitschlitz verschachtelt wird, und wobei das Betreiben der oder jeder Rückkopplungsschleife der AGC-Schaltung in einem Modus mit geschlossener Schleife stattfindet, um einen schnellen Eingriff anzuwenden, um eine Verstärkung des AGC-Verstärkers mit variabler Verstärkung der AGC-Schaltung zu verändern, wenn ein HF-Signal als erstes in einem Signal-Zeitschlitz empfangen wird.

**Revendications**

1. Circuit de commande automatique de gain (noté AGC), comprenant :

> un trajet de transmission vers l'avant possédant une entrée (vers 210) servant à recevoir, en utilisation, un signal de radiofréquence (notée RF) d'entre et une sortie (de 212) servant à fournir, en utilisation, un signal de bande de base de sortie ;
> un amplificateur AGC à gain variable (210) placé dans le trajet de transmission vers l'avant, lequel amplificateur possède une entrée de commande et répond à un signal de commande (240) qui lui est appliqué de façon à faire varier son gain ;

une boude de réaction (200), couplée entre la sortie dudit trajet de transmission vers l'avant et ladite entrée de commande dudit amplificateur ;

un intégrateur (230, 232), couplé à ladite entrée de commande dudit amplificateur ; et

une source de tension (234), couplée audit intégrateur et à ladite entrée de commande dudit amplificateur,

où ladite boude de réaction comporte un détecteur de signal (218) qui possède une réponse de gain non linéaire prédéterminée selon laquelle le gain augmente de façon continue pendant l'augmentation du niveau du signal d'entrée ;

où le circuit AGC est en mesure de recevoir un signal RF produit en une pluralité de tranches de temps de signal,

**caractérisé en ce que** chaque paire de tranches de signal est entrelacée avec au moins une tranche de temps vide, et la boucle de réaction est en mesure de se trouver dans un mode boude fermée afin d'appliquer une attaque rapide pour modifier le gain de l'amplificateur à gain variable lorsqu'un signal RF se trouvant dans la tranche de temps de signal est d'abord reçu.

2. Circuit AGC selon la revendication 1, où le trajet vers l'avant comporte un filtre passe-bas (414) et au moins deux boucles de réaction sont connectées entre le trajet de transmission vers l'avant et l'entrée de commande de l'amplificateur, comportant une première boude de réaction connectée au trajet de transmission vers l'avant avant le filtre passe-bas et une deuxième boucle de réaction connectée au trajet de transmission vers l'avant après le filtre passe-bas, chacune des boucles de réaction incorporant un détecteur (418, 420) de signal de base, qui possède une réponse de gain non linéaire.

3. Circuit AGC selon la revendication 1 ou 2, où le détecteur, ou chaque détecteur, est en mesure d'avoir un gain qui augmente pendant une attaque rapide alors que la boude de réaction est dans le mode boude fermée.

4. Circuit AGC selon l'une quelconque des revendications précédentes, où le détecteur, ou chaque détecteur, est en mesure d'avoir une largeur de bande qui augmente pendant l'attaque rapide alors que la boude de réaction est dans le mode boucle fermée.

5. Circuit AGC selon l'une quelconque des revendications précédentes, qui comporte un moyen de commutation (244) qui est en mesure de faire commuter la boude de réaction, ou chaque boude de réaction, entre un premier mode de fonctionnement dans lequel la boude de réaction, ou chaque boude de réaction, est ouverte et un deuxième mode de réaction dans lequel la boucle de réaction, ou chaque boude de réaction, est fermée, ces modes étant obtenus à des moments prédéterminés pendant des durées prédéterminées.

6. Circuit AGC selon la revendication 5, où le premier mode de fonctionnement est appliqué pendant des tranches de temps vides et le deuxième mode de fonctionnement est appliqué pendant des tranches de temps de signal.

7. Circuit AGC selon la revendication 6, où le deuxième mode de fonctionnement commence pendant une tranche de temps vide avant le début d'une tranche de temps de signal.

8. Circuit AGC selon l'une quelconque des revendications 5 à 7,
où l'amplificateur à gain variable (210) est en mesure d'avoir une atténuation minimale lorsque la boude de réaction commute du premier mode de fonctionnement au deuxième mode de fonctionnement.

9. Circuit AGC selon l'une quelconque des revendications précédentes, qui comporte un mélangeur (212) connecté à une sortie de l'amplificateur à gain variable.

10. Circuit AGC selon la revendication 9, où le mélangeur est un mélangeur abaisseur fournissant, en fonctionnement, un signal de fréquence de bande de base détecté.

11. Circuit AGC selon l'une quelconque des revendications précédentes, où le signal de fréquence de bande de base de sortie du trajet de transmission vers l'avant comporte, comme composantes de phase, une composante en phase (I) et une composante en quadrature (Q).

12. Circuit AGC selon la revendication 11, où ledit détecteur de signal, ou chaque dit détecteur de signal, comprend un détecteur AGC, qui, en utilisation, reçoit ledit signal de bande de base et fournit un signal de sortie à l'entrée de commande dudit amplificateur, le signal de sortie étant associé à une combinaison desdites composantes de phase I et Q dudit signal de bande de base.

13. Circuit AGC selon l'une quelconque des revendications précédentes, où la dépendance du gain G du détecteur de signal ou de chaque détecteur de signal, sur le niveau S dudit signal de bande de base qui lui est présenté est représentée par :

$$G = G_0 + kS^{1+\Delta},$$

où $G_0$, k et $\Delta$ sont des paramètres prédéterminés ($G_0$, k, $\Delta$ > 0).

14. Circuit AGC selon l'une quelconque des revendications précédentes, où le détecteur, ou chaque détecteur, fournit une dépendance de la largeur de bande variable BW, vis-à-vis du niveau S du signal de bande de base d'entrée, qui est représentée par :

$$BW = A.(1+\Delta).S^{\Delta}$$

où BW est la largeur de bande de la boucle, S est l'intensité du signal, tandis que A et $\Delta$ sont des paramètres prédéterminés.

15. Circuit AGC selon l'une quelconque des revendications précédentes, où ledit intégrateur comprend un condensateur d'intégration (232) et une résistance (230), le condensateur d'intégration ayant une sortie via la résistance couplée à ladite entrée de commande dudit amplificateur AGC.

16. Circuit AGC selon l'une quelconque des revendications précédentes, où l'entrée de commande de l'amplificateur AGC à gain variable comporte un étage de commande fournissant, en fonctionnement, une variation sensiblement linéaire du gain ou une atténuation de l'amplificateur en réponse à une variation de la tension qui lui est appliquée.

17. Circuit AGC selon l'une quelconque des revendications précédentes, où ladite source de tension fournit audit intégrateur, de manière à ainsi déterminer le niveau dudit signal de commande, une tension prédéterminée pendant une durée prédéterminée qui commence à un instant prédéterminé.

18. Circuit AGC selon la revendication 17, comportant un commutateur qui est en mesure de connecter la source de tension à l'intégrateur, où le circuit AGC possède un premier mode de fonctionnement dans lequel la boucle de réaction, ou chaque boude de réaction, est ouverte et un deuxième mode de fonctionnement dans lequel la boude de réaction, ou chaque boucle de réaction, est fermée, et le commutateur est en mesure de connecter la source de tension à l'intégrateur pendant le premier mode de fonctionnement.

19. Circuit AGC selon la revendication 17, où le moyen de commutation comporte un commutateur électriquement activé (244) qui sert à connecter à l'intégrateur une borne de sortie du détecteur de signal, un ou plusieurs commutateurs électriquement commandés (236, 238) servant à connecter la source de tension à l'intégrateur et l'intégrateur à l'entrée de commande de l'amplificateur à gain variable, et un dispositif de commande (226) servant à fournir des signaux afin d'activer les commutateurs pour assurer la commutation entre les premier et deuxième modes.

20. Circuit AGC selon l'une quelconque des revendications précédentes, où la boude de réaction, ou chaque boude de réaction, est en mesure d'avoir un temps de stabilisation, lors d'une attaque rapide, qui est inférieur à 0,2 ms.

21. Circuit AGC selon l'une quelconque des revendications précédentes, où la boude de réaction, ou chaque boucle de réaction, est en mesure de détecter un signal qui possède une gamme dynamique de 80 dB.

22. Récepteur de radiofréquence (notée RF) comportant un circuit AGC tel que défini dans l'une quelconque des revendications précédentes.

23. Récepteur RF selon la revendication 22, qui est en mesure de recevoir des signaux RF produits en une pluralité de tranches de temps de signal, chaque paire de tranches de temps de signal adjacentes étant entrelacée avec au moins une tranche de temps vide.

24. Récepteur RF selon la revendication 23, où le circuit AGC possède un premier mode de fonctionnement dans lequel la boucle de réaction, ou chaque boude de réaction, n'est pas fonctionnelle et un deuxième mode de fonctionnement dans lequel la boude de réaction, ou chaque boucle de réaction, est fonctionnelle, ces modes étant obtenus en alternance à des moments prédéterminés pendant des intervalles de temps prédéterminés qui correspondent à un motif des tranches de temps de signal et des tranches de temps vides.

25. Récepteur RF selon la revendication 24, où le premier mode de fonctionnement débute après la fin de chaque tranche de temps de signal.

26. Récepteur RF selon la revendication 24 ou 25, où le deuxième mode de fonctionnement débute avant le début de chaque tranche de temps de signal.

27. Récepteur RF selon l'une quelconque des revendications 22 à 26, où le signal à détecter est un signal de communications en mode direct.

28. Récepteur RF selon l'une quelconque des revendications 22 à 27, où le signal à détecter est transmis en fonction de normes de mode direct TETRA.

29. Procédé de détection d'un signal RF fourni dans une pluralité de tranches de temps de signal, **caractérisé en ce que** chaque paire de tranches de temps de signal adjacentes est entrelacée avec au moins une tranche de temps vide, le procédé comportant l'utilisation d'un récepteur RF tel que défini dans l'une quelconque des revendications 22 à 28 pour détecter le signal.

30. Procédé selon la revendication 29, comportant l'application, à l'entrée du trajet de transmission vers l'avant du circuit AGC comportant l'amplificateur AGC à gain variable, d'un signal RF d'entrée et fournissant, à la sortie du trajet de transmission vers l'avant et à l'entrée d'un détecteur AGC du circuit AGC, un signal de bande de base ;
où le signal RF est reçu en une pluralité de tranches de temps de signal, chaque paire de tranches de signal étant entrelacée avec au moins une tranche de temps vide, et activant la boucle de réaction, ou chaque boucle de réaction, du circuit AGC de façon qu'elle soit dans un mode boude fermée afin d'appliquer une attaque rapide pour ainsi modifier le gain de l'amplificateur AGC à gain variable du circuit AGC lorsqu'un signal RF est d'abord reçu dans une tranche de temps de signal.

*210*   *214*   *212*

INPUT
SIGNAL → AGC
AMP → DOWN
MIXER → I&Q BASEBAND SIGNAL

*240*

*220* — I&Q

*216* — DRIVER

*244*

AGC
DETECTOR
$I^2+Q^2$ — *218*

*238* — CONTROLLER — *226*

*230*

$R_{AGC}$

*236*

*232*

$C_{AGC}$

*234*

$V_{PRESET}$

*200*

*FIG. 1*

DETECTOR
GAIN

$10^4$

$10^3$

$10^2$

STEEP SLOPE,
HIGH GAIN

$10^1$

DESIRED
SIGNAL
LEVEL

$10^0$

SHALLOW SLOPE,
LOW GAIN

SIGNAL
LEVEL

*FIG. 2*

15

OPENING AGC LOOP ~250

SETTING MINIMAL ATTENUATION OF AGC AMPLIFIER ~252

CLOSING AGC LOOP ~254

DETECTING FAST AGC ATTACK ~256

COMMENCING STEADY-STATE AGC OPERATION ~258

## FIG. 3

## FIG. 4

*FIG. 5*